# EUROPÄISCHE PATENTSCHRIFT

(11) **EP 1 569 281 B1**
(45) Veröffentlichungstag und Bekanntmachung des Hinweises auf die Patenterteilung: **01.08.2018**
(21) Anmeldenummer: 05002202.9
(22) Anmeldetag: 02.02.2005
(51) Int. Cl.: H01L 33/00, H01L 33/44

(54) **Strahlungsemittierender Halbleiterchip und Verfahren zur Herstellung eines solchen Halbleiterchips**
Light emitting diode and method of manufacturing the same
Diode électroluminescente et procédé de fabrication

(30) Priorität: 27.02.2004 DE 102004009624; 18.06.2004 DE 102004029412
(43) Veröffentlichungstag der Anmeldung: 31.08.2005
(73) Patentinhaber: OSRAM Opto Semiconductors GmbH, 93055 Regensburg (DE)
(72) Erfinder: Völkl, Johannes, 91056 Erlangen (DE); Stein, Wilhelm, 88131 Lindau (DE); Walter, Robert, 92331 Parsberg (DE); Zeisel, Roland, 93105 Tegernheim (DE); Kus, Oliver, 93133 Burglengenfeld (DE)
(74) Vertreter: Epping - Hermann - Fischer

(56) Entgegenhaltungen:
- EP-A1- 0 404 565
- EP-A1- 0 645 829
- EP-A2- 0 563 991
- WO-A2-02/075819
- WO-A2-2005/041247
- JP-A- 11 145 519
- JP-A- 60 171 775
- US-B1- 6 603 146
- US-B1- 6 653 765
- CHAND N ET AL: "Molecular beam deposition of high quality silicon oxide dielectric films", J. CRYSTAL GROWTH, Bd. 148, 1. März 1995 (1995-03-01), Seiten 336-344, XP004004656, ISSN: 0022-0248, DOI: DOI:10.1016/0022-0248(94)00729-2
- HONG J ET AL: "Influence of high-temperature firing step on high-rate plasma deposited silicon nitride films", J. VACUUM SCIENCE & TECHNOL B, Bd. 21, 1. September 2003 (2003-09-01), Seiten 2123-2132, XP012010075, ISSN: 0734-211X, DOI: DOI:10.1116/1.1609481
- NAGEL H ET AL: "Optimised AR coatings for planar silicon solar cells using remote PECVD silicon nitride and porous silicon dioxide", PROGRESS IN PV RESEARCH, Bd. 7, 1. Juli 1999 (1999-07-01), Seiten 245-260, XP000950137, ISSN: 1062-7995, DOI: DOI:10.1002/(SICI)1099-159X(199907/08)7:4< 245::AID-PIP255>3.3.CO;2-V
- ZHENG J-Z ET AL: "Characterization and in-line control of UV-transparent silicon nitride films", PROCEEDINGS OF SPIE, Bd. 2876, 1. Oktober 1996 (1996-10-01), Seiten 63-70, XP000853654, ISSN: 0277-786X, DOI: DOI:10.1117/12.250915

## Beschreibung

Die Erfindung betrifft einen strahlungsemittierenden Halbleiterchip mit einer Halbleiterschichtenfolge, die mindestens eine elektromagnetische Strahlung erzeugende aktive Schicht umfasst, und mit einer auf der strahlungsaustretenden Seite der Halbleiterschichtfolge angeordneten Passivierungsschicht. Die Erfindung betrifft weiterhin ein Verfahren zur Herstellung solcher Halbleiterchips.

Die Halbleiterschichten von Halbleiterchips, beispielsweise die strahlungserzeugenden Schichtstrukturen von strahlungsemittierenden und von strahlungsempfangenden Halbleiterchips können durch eine Vielzahl von unterschiedlichen Epitaxie-Methoden, wie metallorganische Dampfphasenepitaxie (Metal Organis Vapor Phase Epitaxy (MOVPE)), Molekularstrahlepitaxie (Molecular Beam Epitaxy (MBE)), Flüssigphasenepitaxie (Liquid Phase Epitaxy (LPE)), etc. definiert werden. Alternativ oder ergänzend können solche Schichtstrukturen zumindest teilweise durch Eindiffundieren von Dotierstoffen definiert werden.

Sowohl Epitaxie-Prozesse als auch Dotierprozesse unterliegen gewissen Fertigungsschwankungen. Bei lichtemittierenden Halbleiterchips führen Fertigungsschwankungen häufig zu Schwankungen in der Helligkeit von nominal gleichartigen Halbleiterchips im Betrieb. Sowohl die in unterschiedlichen Epitaxie-Prozessläufen hergestellten Wafer, als auch die gleichzeitig in einem Prozesslauf hergestellten verschiedenen Wafer unterliegen Fertigungsschwankungen, wobei die Schwankungen innerhalb der in einem Prozesslauf hergestellten Wafer geringer sind.

Bei der Herstellung eines strahlungsemittierenden Halbleiterchips, dessen Strahlungsemission während der Herstellung auf einen bestimmten Bereich einstellbar ist, ist es wünschenswert, wenn der Epitaxie-Prozess, der durch seine Komplexität großen Schwankungen unterworfen ist, unbeeinflusst bleiben kann. Ziel wäre es somit, bestimmte Helligkeitsklassen der strahlungsemittierenden Halbleiterchips herstellen zu können, ohne dabei Prozessänderungen in dem Epitaxie-Prozess vornehmen zu müssen.

Diesen Gesichtspunkt berücksichtigend, sind beispielsweise Halbleiterchips bekannt, bei denen zwischen einem Anschlussbereich und der aktiven Schicht des Halbleiterchips eine Helligkeitseinstellschicht angeordnet ist, die mindestens einen elektrisch isolierenden Stromsperrbereich und mindestens einen elektrisch leitenden Durchlassbereich umfasst. Der Stromdurchlassbereich verbindet den Anschlussbereich und die Halbleiterschichtenfolge derart elektrisch leitend miteinander, dass im Bereich des Halbleiterchips Strom unter dem Anschlussbereich in die Halbleiterschichtenfolge injiziert wird. Ein Teil der im Halbleiterchip erzeugten elektromagnetischen Strahlung wird dabei unter dem Anschlussbereich erzeugt und von diesem absorbiert. Durch Einstellung von Größe und Lage des Stromdurchlassbereichs kann der Anteil der im Halbleiterchip erzeugten Strahlung, die aus diesem nicht ausgekoppelt wird, eingestellt werden.

Die Helligkeitseinstellschicht ermöglicht es, auch aus Wafern mit unterschiedlichen Helligkeiten, wie sie beispielsweise aufgrund von Schwankungen im Epitaxie- und/oder Dotierprozess oder aufgrund von Schwankungen zwischen verschiedenen Prozessläufen entstehen können, Halbleiterchips herzustellen, deren Helligkeit vergleichsweise sicher innerhalb eines vorgegebenen Soll-Helligkeitsbereich liegen. Die beschriebene Struktur erzielt mit gleichartig epitaxierten Halbleiterschichtfolgen Halbleiterchips mit anwendungsabhängig gezielt unterschiedlichen Helligkeiten.

Ein Nachteil dieser Vorgehensweise besteht darin, dass zur Herstellung des strahlungsemittierenden Halbleiterchips gegenüber dem standardisierten Herstellungsvorgang geänderte und zusätzliche Masken benötigt werden. Die zusätzlichen Herstellungsschritte bedingen eine unerwünschte Erhöhung der Produktionskosten. In der Druckschrift WO 02/075819 A2 ist ein strahlungsemittierender Halbleiterchip beschrieben, bei dem eine Vergütungsschicht zur Absorption von kurzwelliger Strahlung aufgebracht ist.

In der Druckschrift EP 0 563 991 A2 ist ein Licht emittierendes Bauelement beschrieben, bei dem die Intensität der externen Lichtemission auch bei einem Temperaturanstieg konstant bleiben soll. Hierfür ist ein optisches Filter vorgesehen, das die Abnahme einer Emissionsintensität durch eine Zunahme in seiner Transmissivität kompensiert.

Aus der Druckschrift JP 60171775 A sind Filter für Licht emittierende Elemente bekannt, bei der verschiedene Schichten aus amorphem SiN, SiGe oder SiSn abgeschieden werden, welche jeweils unterschiedliche Absorptionswellenlängen aufweisen.

Der Erfindung liegt daher die Aufgabe zugrunde, eine Halbleiterstruktur anzugeben, deren Strahlungsemission während der Herstellung auf einen Sollbereich auf einfachere und kostengünstigere Weise als im Stand der Technik einstellbar ist. Eine weitere Aufgabe besteht darin, ein Verfahren zur Herstellung derartiger Halbleiterchips zur Verfügung zu stellen.

Diese Aufgaben werden durch einen Halbleiterchip mit den Merkmalen des Patentanspruches 1 sowie durch ein Verfahren mit den Merkmalen des Patentanspruchs 4 gelöst.

Eine nicht erfindungsgemäße Variante macht sich die Tatsache zu Nutze, dass strahlungsemittierende Halbleiterchips häufig mit einer Vergütungsschicht auf der strahlungsaustretenden Seite versehen sind, die die Entspiegelung des Chips bewirkt. Der Transmissionsgrad dieser Passivierungsschicht kann nun beim Aufbringen auf die Halbleiterschichtenfolge, die mindestens eine elektromagnetische Strahlung erzeugende aktive Schicht umfasst, in ihrer Zusammensetzung beeinflusst werden, in deren Abhängigkeit sich der Transmissionsgrad einstellen lässt. Die Passivierungsschicht kann auf diese Weise auf einen gewünschten Transmissionsgrad eingestellt werden.

Insbesondere kann der Transmissionsgrad der aufgebrachten Passivierungsschicht, etwa über gezielte und/oder für eine vorgegebene Transmission gewünschte Beeinflussung ihrer Zusammensetzung beim Aufbringen, unabhängig von der Dicke der Passivierungsschicht eingestellt werden. Über die Zusammensetzung der Passivierungsschicht ist hierbei im Besonderen der dickenunabhängige Transmissionskoeffizient der Passivierungsschicht einstellbar.

Bevorzugt besteht die Passivierungsschicht aus einem dielektrischen Material und weist eine flüchtige Komponente auf, wobei der Grad der Abreicherung der flüchtigen Komponente während der Herstellung der Passivierungsschicht die Transmissionseigenschaft der Passivierungsschicht beeinflusst.

Die Passivierungsschicht kann vorteilhafterweise durch ein reaktives Sputterverfahren auf die Halbleiterschichtenfolge aufgebracht werden. Durch die gezielte Abreicherung einer flüchtigen Komponente des Passivierungsmaterials, z.B. O₂ oder N₂, kann der Transmissionsgrad der Passivierungsschicht stufenlos oder nahezu stufenlos eingestellt werden.

Als Material der Passivierungsschicht kommt insbesondere ein Siliziumnitrid, wie SiN, ein Siliziumoxid, wie SiO₂, ein Aluminiumoxid, wie Al₂O₃, oder ein Siliziumoxinitrid, wie SiON, in Betracht.

Die nicht erfindungsgemäße Variante beruht auf dem Prinzip, den standardisierten Schritt des Aufbringens einer als Vergütungsschicht wirkenden Passivierungsschicht hinsichtlich der Zusammensetzung des Passivierungsmaterials zu beeinflussen, um die Passivierungsschicht teilabsorbierend und folglich den Halbleiterchip dunkler werden zu lassen. Durch eine geeignete Prozessführung kann eine stufenlose Abdunkelung des Halbleiterchips bewirkt werden.

Die Halbleiterchip-Struktur gemäß der vorliegenden Erfindung ermöglicht es in vorteilhafter Weise, mit gleichartig epitaxierten Halbleiterschichtfolgen Halbleiterchips mit beispielsweise anwendungsabhängig gezielt unterschiedlichen Helligkeiten herzustellen. Es ist deshalb vorteilhafterweise nicht mehr durchweg erforderlich, für die Herstellung von Halbleiterchips mit unterschiedlichen Helligkeiten unterschiedliche Epitaxie-Prozesse einzusetzen. Eine Epitaxie-Anlage kann folglich in gesteigertem Maße mit gleichbleibenden Prozessabfolgen betrieben werden, was insgesamt zu einer Stabilisierung von Epitaxie-Prozessen beiträgt.

Um Chip-Chargen innerhalb des Soll-Helligkeitsbereiches einzustellen, ist es zweckmäßig, eher sehr helle Chips zu fertigen, die dann nach Fertigstellung der Halbleiterschichtenfolge durch die in erfindungsgemäßer Weise beeinflusste Passivierungsschicht auf ein je nach Applikation gewünschtes einheitliches Niveau verdunkelt werden.

Die gleichen Vorteile sind auch mit der Erfindung gemäß Patentanspruch 1 verbunden, bei der die Passivierungsschicht eine Helligkeitseinstellschicht umfasst, die im Betrieb des Halbleiterchips einen Teil der im Chip erzeugten elektromagnetischen Strahlung absorbiert. Das Vorsehen einer Helligkeitseinstellschicht in der Passivierungsschicht ermöglicht gegenüber der aus dem Stand der Technik bekannten Chipstruktur den Einsatz standardisierter Herstellungsschritte, wobei lediglich der letzte Schritt des Aufbringens der Passivierungsschicht geringfügig angepasst werden muss. Die Helligkeitseinstellschicht bietet, ohne Eingriff in den Epitaxieprozess, die Möglichkeit der Variation der Transmission der Passivierungsschicht und dadurch eine Verringerung der Licht-Auskopplung. Der Grad der Transmission kann dabei gemäß einer gewünschten Vorgabe genau eingestellt werden.

Die Integration der Helligkeitseinstellschicht in der Passivierungsschicht erfolgt dabei der Gestalt, dass die durch die Passivierungsschicht beabsichtigte Funktion einer elektrischen Isolierung der Oberfläche und des pn-Überganges in keiner Weise beeinträchtigt wird.

Die Helligkeitseinstellschicht ist zwischen einer ersten und einer zweiten Schicht der Passivierungsschicht angeordnet. Die Helligkeitseinstellschicht ist aus einem amorphen Silizium gebildet. Die erste und die zweite Schicht der Passivierungsschicht enthalten bevorzugt SiN, SiO oder SiON.

Die Variation der Transmission dieser Passivierungsschicht ist durch die Dicke der Helligkeitseinstellschicht festgelegt. Das Ausbilden der Helligkeitseinstellschicht erfolgt dabei bevorzugt mittels chemischer Gasphasenabscheidung, mittels der die Dicke über die Dauer der Behandlung eingestellt werden kann.

Vorteil hiervon ist, dass die Beeinflussung des Transmissionsgrades am Halbleiterchip nicht mittels visueller Methoden festgestellt werden kann. Das Herstellen der Helligkeitseinstellschicht kann auf einfache Weise im Prozess der Abscheidung der Passivierungsschicht eingebaut werden. Von Vorteil ist ebenfalls, dass Licht, das aus der Mesakante der Chipstruktur austritt, ebenfalls bei der Herstellung erfasst wird, so dass eine homogene Lichtanpassung sichergestellt ist.

Die erfindungsgemäßen Halbleiterstrukturen ermöglichen es, die Produktion der Halbleiterchips an wechselnde Kundenbedürfnisse hinsichtlich der Helligkeit bzw. des Licht-Auskoppelungswirkungsgrades optimal abzustimmen. Hierdurch verringert sich die Gefahr einer Lagerbildung durch nicht benötigte Lichtklassen.

Prinzipiell eignet sich die Erfindung für strahlungsemittierende Halbleiterchips, die auf beliebigen, zur Strahlungserzeugung geeigneten Halbleitermaterialsystemen basieren. Bevorzugt enthält der Halbleiterchip, insbesondere die aktive Schicht, ein III-V-Halbleitermaterial, etwa ein Halbleitermaterial aus den Materialsystemen InₓGa_{y}Al_{1-x-y}P,
InₓGa_{y}Al_{1-x-y}N oder InₓGa_{y}Al_{1-x-y}As, jeweils mit 0≤x≤1, 0≤y≤1 und x+y≤1. Derartige Halbleitermaterialien zeichnen sich durch vorteilhaft hohe Quanteneffizienzen bei der Strahlungserzeugung aus. InₓGa_{y}Al_{1-x-y}P beispielsweise ist für Strahlung vom infraroten bis in den gelben oder orangen und InₓGa_{y}Al_{1-x-y}N beispielsweise für Strahlung vom grünen bis in den ultravioletten Spektralbereich besonders geeignet.

Insbesondere bei Halbleiterchips, die auf Halbleitermaterialsystemen basieren, welche für die Erzeugung von Strahlung im im ultravioletten oder sichtbaren Spektralbereich geeignet sind, kann im Rahmen der Erfindung der Transmissionsgrad einer teilabsorbierenden Passivierungsschicht besonders effizient eingestellt werden.

Weitere Vorteile, vorteilhafte Ausführungsformen und Weiterbildungen ergeben sich aus den nachfolgenden in Verbindung mit den Figuren erläuterten Ausführungsbeispielen.

Es zeigen:
- Figur 1: eine schematische Darstellung eines Querschnittes durch einen Halbleiterchip gemäß einer nicht erfindungsgemäßen Variante,
- Figur 2: eine schematische Darstellung eines Querschnittes durch einen Halbleiterchip gemäß einer erfindungsgemäßen Variante,
- Figur 3: eine Tabelle mit verschiedenen Parametern zur Erzeugung von Helligkeitseinstellschichten mit unterschiedlichen Transmissionsgraden gemäß der erfindungsgemäßenVariante, und
- Figur 4: ein Diagramm, aus dem die Relation des Transmissionsgrades zur Schichtdicke der Helligkeitseinstellschicht gemäß der erfindungsgemäßen Variante hervorgeht.

In den Ausführungsbeispielen sind gleiche oder gleichwirkende Bestandteile jeweils gleich bezeichnet und mit den gleichen Bezugszeichen versehen. Die dargestellten Schichtdicken sind nicht maßstabsgerecht. Sie sind vielmehr zum besseren Verständnis übertrieben dick und nicht mit den tatsächlichen Dickenverhältnissen zueinander dargestellt.

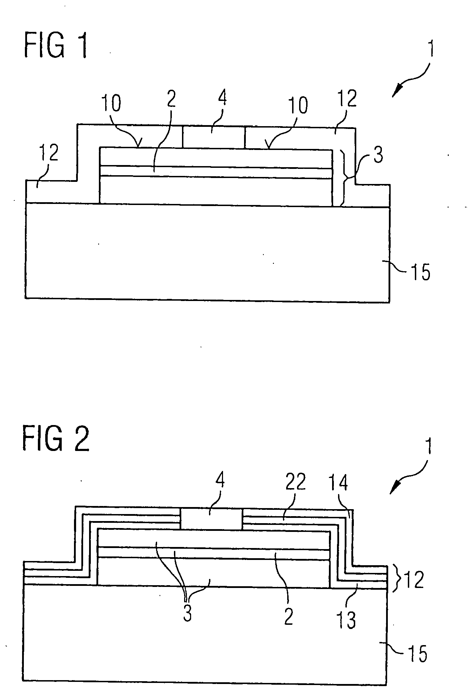

Bei dem in Figur 1 dargestellten Beispiel gemäß einer nicht erfindungsgemäßen Variante und in Figur 2 dargestellten Ausführungsbeispiel einer erfindungsgemäßen Variante handelt es sich jeweils um einen strahlungsemittierenden Halbleiterchip 1 mit einer Halbleiterschichtenfolge 3, die eine elektromagnetische Strahlung erzeugende aktive Schicht 2 aufweist. Diese aktive Schicht 2 kann aus einer einzelnen Halbleiterschicht bestehen oder eine Mehrzahl von Halbleiterschichten aufweisen, die beispielsweise eine Multi-Quantentopfstruktur ausbilden.

Auf der Halbleiterschichtenfolge 3 ist jeweils eine Passivierungsschicht 12 mit einem Anschlussbereich 4 aufgebracht. Der Anschlussbereich 4 ist beispielsweise ein kreisförmiger Bondpad. Der Anschlussbereich 4 kann je nach Bedarf auch eine andere Geometrie aufweisen.

Gemäß der nicht erfindungsgemäßen Variante nach Figur 1 stellt die Passivierungsschicht 12 eine Vergütungsschicht auf der strahlungsaustretenden Seite dar, die aus einem dielektrischen Material, z.B. SiN, SiO₂, Al₂O₃, besteht und eine Entspiegelung des strahlungsemittierenden Halbleiterchips bewirkt. Über die Passivierungsschicht wird beim Aufbringen der selben der Transmissionsgrad des Halbleiterchips eingestellt. Die Passivierungsschicht wird z.B. durch ein reaktives Sputterverfahren hergestellt. Dabei wird von einem metallischen Target elementares Metall abgetragen und durch Beimischung von O₂ oder N₂ zur gewünschten Verbindung durchreagiert. Durch eine gezielte Verringerung des notwendigen O₂- oder N₂-Partialdruckes im Plasma der Sputterbeschichtung kann nun die Transparenz der Vergütungsschicht verringert werden. Im Extremfall kann eine reine, vollkommen lichtundurchlässige Metallschicht abgeschieden werden.

Allgemeiner formuliert wird vorgeschlagen, eine flüchtige Komponente des Vergütungsmaterials der Passivierungsschicht beim Beschichtungsprozess gezielt abzureichern, um die betreffende Passivierungsschicht teilabsorbierend zu machen, wodurch der Halbleiterchip dunkler wird. Prinzipiell kann durch die Prozessführung beim Erzeugen der Passivierungsschicht eine stufenlose Abdunkelung des strahlungsemittierenden Chips bewirkt werden.

Insbesondere kann so der Transmissionsgrad der aufgebrachten Passivierungsschicht über gezielte Beeinflussung, etwa einer Variation, der Zusammensetzung der Passivierungsschicht bei ihrer Aufbringung weitestgehend unabhängig von der Dicke der Passivierungsschicht eingestellt werden. Über die Zusammensetzung der Passivierungsschicht kann insbesondere der dickenunabhängige Transmissionskoeffizient der Passivierungsschicht eingestellt werden.

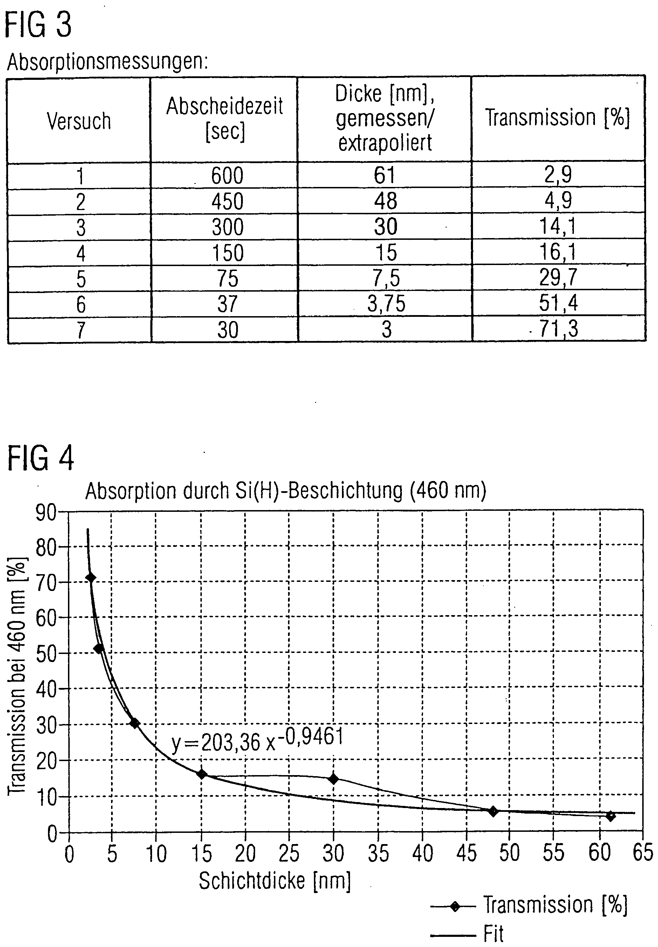

Bei der erfindungsgemäßen Variante gemäß Figur 2 umfasst die Passivierungsschicht 12 eine Helligkeitseinstellschicht 22, die zwischen einer ersten und einer zweiten Schicht 13,14 der Passivierungsschicht angeordnet ist. Der Transmissionsgrad der Helligkeitseinstellschicht ist durch die Dicke derselben festgelegt. Die im Rahmen mehrerer Versuche erzielten Dicken der Helligkeitseinstellschicht in Abhängigkeit der Abscheidezeit einer Plasma angeregten chemischen Gasphasenabscheidung (PECVD) können der Tabelle in Figur 3 entnommen werden. Mit zunehmender Abscheidezeit lässt sich eine größere Dicke der Helligkeitseinstellschicht erzielen. Der aufgefundene Zusammenhang zwischen der Schichtdicke der Helligkeitseinstellschicht und dem Transmissionsgrad bei einer Wellenlänge von 460 nm ist aus der Figur 4 ersehbar. Mit zunehmender Schichtdicke sinkt der Transmissionsgrad annähernd exponentiell ab.

Für die Versuche gemäß der Tabelle in Figur 3 wurde die Helligkeitseinstellschicht auf einem transparenten Substrat hergestellt und nachfolgend die Transmission der Helligkeitseinstellschicht des jeweiligen Versuchs bei einer Wellenlänge von 460 nm bestimmt.

Die Helligkeitseinstellschicht 22 ist aus amorphen Silizium, bevorzugt aus amorphen PECVD-Silizium, ausgebildet, während die erste und die zweite Schicht 13, 14 der Passivierungsschicht 12 aus PECVD-SiN bzw. SiO- bzw. SiON-Schichten ausgebildet sind.

Diese PECVD-Schichten werden bevorzugt in einem Temperaturbereich von einschließlich 80 °C bis einschließlich 400 °C abgeschieden, wobei ein Temperaturbereich von einschließlich 200 °C bis einschließlich 300 °C besonders bevorzugt ist. Der Druck während des Abscheidens beträgt beispielsweise zwischen einschließlich 0,5 und einschließlich 4 Torr. Als Prozessgase bei der Herstellung der Schichten werden zum Beispiel SiH₄, He, N₂, N₂O und/oder NH₃ in verschiedenen Mischungsverhältnissen verwendet.

Ein besonderer Vorteil der Erfindung besteht darin, dass der mittels der Helligkeitseinstellschicht variierbare Transmissionsgrad am Halbleiterchip nicht mittels visuellen Methoden feststellbar ist. Dies gilt im übrigen auch für die nicht erfindungsgemäße Variante mit der als Vergütungsschicht ausgebildeten Passivierungsschicht. Da die Helligkeitseinstellschicht 22 Teil der Passivierungsschicht 12 ist, wird Licht, das aus der Mesakante austritt, ebenfalls in seiner Transmission gemäß dem gewünschten Licht-Auskoppelungswirkungsgrad erfasst, so dass der Halbleiterchip insgesamt eine homogene Lichtabstrahlungscharakteristik aufweist.

Die eigentliche Funktion der elektrischen Isolierung der Oberfläche und des pn-Übergangs wird bei beiden Varianten gemäß Figur 1 und 2 trotz Modifikationen gegenüber einer herkömmlichen Halbleiterstruktur nicht beeinflusst. Beide Varianten erlauben eine prozesskompatible Integration der jeweils notwendigen Prozessschritte während des standardmäßig durchgeführten Passivierungsprozesses zur Ausbildung der Passivierungsschicht.

Die Erfindung ist nicht durch die Beschreibung anhand der Ausführungsbeispiele beschränkt.

## Patentansprüche

1. Strahlungsemittierender Halbleiterchip (1) mit einer Halbleiterschichtenfolge (3), die mindestens eine eine elektromagnetische Strahlung erzeugende aktive Schicht (2) umfasst, und mit einer auf der Strahlungsaustretenden Seite der Halbleiterschichtfolge (3) angeordneten Passivierungsschicht (12),
**dadurch gekennzeichnet, dass**
die Passivierungsschicht (12) eine Helligkeitseinstellschicht (22), eine erste und eine zweite Schicht (13, 14)umfasst, wobei die Helligkeitseinstellschicht (22) mit amorphem Silizium gebildet und zwischen der ersten und der zweiten Schicht (13,14) angeordnet ist, und im Betrieb des Halbleiterchips (1) einen Teil der im Chip erzeugten elektromagnetischen Strahlung absorbiert.

2. Halbleiterchip nach Anspruch 1,
**dadurch gekennzeichnet, dass**
der Transmissionsgrad der Helligkeitseinstellschicht (22) durch die Dicke der Helligkeitseinstellschicht (22) festgelegt ist.

3. Halbleiterchip nach Anspruch 1 oder 2,
**dadurch gekennzeichnet, dass**
die erste und die zweite Schicht (13,14) der Passivierungsschicht (12) SiN, SiO oder SiON enthalten.

4. Verfahren zum Herstellen eines Halbleiterchips mit einer Helligkeit innerhalb eines Soll-Helligkeitsbereichs mit den Schritten:
- Herstellen einer Halbleiterschichtenfolge (3) mit mindestens einer eine elektromagnetische Strahlung erzeugenden aktiven Schicht (2) auf einem Substrat (15);
- Aufbringen einer Passivierungsschicht (12) mit einer ersten und einer zweiten Schicht (13, 14)auf der Strahlungsaustretenden Seite der Halbleiterschichtfolge (3), wobei beim
Aufbringen der Passivierungsschicht (12) zwischen der ersten und der zweiten Schicht (13,14) eine Helligkeitseinstellschicht (22) mit amorphem Silizium ausgebildet wird, wobei die Helligkeit über die Dicke der Helligkeitseinstellschicht festgelegt wird, sodass der Halbleiterchip auf eine Helligkeit innerhalb des Soll-Helligkeitsbereichs abgedunkelt wird.

5. Verfahren nach Anspruch 4,
**dadurch gekennzeichnet, dass**
das Aufbringen der Passivierungsschicht das Ausbilden folgender Schichtfolge umfasst:
- eine erste Schicht (13) aus einem ersten dielektrischen Material auf der Strahlungsaustretenden Seite der Halbleiterschichtfolge (3);
- eine zweite Schicht (14) aus dem ersten dielektrischen Material auf der Helligkeitseinstellschicht (22).

6. Verfahren nach Anspruch 4 oder 5,
**dadurch gekennzeichnet, dass**
das Ausbilden der Helligkeitseinstellschicht (22) mittels chemischer Gasphasenabscheidung erfolgt.

## Claims

1. Radiation-emitting semiconductor chip (1) having a semiconductor layer sequence (3) comprising at least one active layer (2), which generates an electromagnetic radiation, and having a passivation layer (12) arranged on the radiation-emerging side of the semiconductor layer sequence (3),
**characterized in that**
the passivation layer (12) comprises a brightness setting layer (22), a first and a second layer (13, 14), wherein the brightness setting layer (22) is formed with amorphous silicon and is arranged between the first and the second layer (13, 14), and the brightness setting layer (22) absorbs a portion of the electromagnetic radiation generated in the chip during operation of the semiconductor chip (1).

2. Semiconductor chip according to claim 1,
**characterized in that**
the degree of transmission of the brightness setting layer (22) is defined by the thickness of the brightness setting layer (22).

3. Semiconductor chip according to claim 1 or 2,
**characterized in that**
the first and the second layer (13, 14) of the passivation layer (12) contain SiN, SiO or SiON.

4. Method for producing a semiconductor chip having a brightness within a desired brightness range with the steps:
- producing a semiconductor layer sequence (3) on a substrate (15), wherein the semiconductor layer sequence (3) has at least one active layer (2), which generates an electromagnetic radiation;
- applying a passivation layer (12) having a first and a second layer (13, 14) on the radiation-emerging side of the semiconductor layer sequence (3), wherein during the application of the passivation layer (12), between the first and the second layer (13, 14), a brightness setting layer (12) with amorphous silicon is formed, wherein the brightness of the brightness setting layer (22) is determined by means of the thickness of the brightness setting layer (22), so that the semiconductor chip is darkened to a brightness within the desired brightness range.

5. Method according to claim 4,
**characterized in that**
the application of the passivation layer comprises the formation of the following layer sequences:
- a first layer (13) of a first dielectric material on the radiation-emerging side of the semiconductor layer sequence (3) ;
- a second layer (14) of the first dielectric material on the brightness setting layer (22).

6. Method according to claim 4 or 5,
**characterized in that**
the formation of the brightness setting layer (22) is carried out by means of chemical gas phase deposition.

## Revendications

1. Puce électronique à semiconducteur émettant une radiation (1) avec une succession de couches de semiconducteurs (3), qui possède au moins une couche active (2) émettant un rayonnement électromagnétique, et avec une couche de passivation (12) disposée sur le côté de sortie de radiation de la succession de couches de semiconducteurs (3),
**caractérisée en ce que**
la couche de passivation (12) comporte une couche de réglage de la luminosité (22), une première et une seconde couche (13, 14), la couche de réglage de la luminosité (22) étant constituée de silicium amorphe et disposée entre la première et la seconde couche (13, 14), et absorbant pendant le fonctionnement de la puce électronique à semiconducteur (1) une partie du rayonnement électromagnétique généré dans la puce.

2. Puce électronique à semiconducteur selon la revendication 1,
**caractérisée en ce que**
le degré de transmission de la couche de réglage de la luminosité (22) est déterminé par l'épaisseur de la couche de réglage de la luminosité (22).

3. Puce électronique à semiconducteur selon les revendications 1 ou 2,
**caractérisée en ce que**
la première et la seconde couche (13, 14) de la couche de passivation (12) contiennent du SiN, du SiO ou du SiON.

4. Procédé en vue de la fabrication d'une puce électronique à semiconducteur avec une luminosité au sein d'une plage de luminosité souhaitée avec les étapes de :
- la fabrication d'une succession de couches de semiconducteurs (3) avec au moins une couche active (2) émettant un rayonnement électromagnétique sur un substrat (15) ;
- l'application d'une couche de passivation (12) avec une première et une seconde couche (13, 14) sur le côté de sortie de radiation de la succession de couches de semiconducteurs (3), une couche de réglage de la luminosité (22) étant constituée de silicium amorphe lors de l'application de la couche de passivation (12) entre la première et la seconde couche (13, 14), la luminosité étant déterminée par l'épaisseur de la couche de réglage de la luminosité, de sorte que la puce électronique à semiconducteur est assombrie à une luminosité au sein de la plage de luminosité souhaitée.

5. Procédé selon la revendication 4,
**caractérisé en ce que**
l'application d'une couche de passivation comporte la constitution de la succession de couches suivante:
- une première couche (13) en une première matière diélectrique sur le côté de sortie de radiation de la succession de couches de semiconducteurs (3);
- une seconde couche (13) en la première matière diélectrique sur la couche de réglage de la luminosité (22).

6. Procédé selon les revendications 4 ou 5,
**caractérisé en ce que**
la constitution de la couche de réglage de la luminosité (22) s'effectue par dépôt chimique en phase vapeur.
